# DEMANDE DE BREVET EUROPEEN

(11) **EP 0 845 817 A1**
(43) Date de publication de la demande: **03.06.1998**
(21) Numéro de dépôt: 97402826.8
(22) Date de dépôt: 25.11.1997
(51) Int. Cl.: H01L 31/107

(54) **Photodiodes à avalanche**

(30) Priorité: 27.11.1996 FR 9614521
(71) Demandeur: FRANCE TELECOM, 75015 Paris (FR)
(72) Inventeur: Barrou, Thomas, 94230 Cachan (FR); Scavennec, André, 75013 Paris (FR)
(74) Mandataire: Texier, Christian

(57) **Abrégé**

Photodiode à avalanche comportant une zone d'absorption (ZA), une zone de multiplication (ZM) et une zone de transition (ZT) disposée entre cette zone d'absorption (ZA) et cette zone de multiplication (ZM), cette zone de transition (ZT) présentant un dopage et étant constituée au moins en partie (2) en un matériau à composition graduelle tel que les bandes d'énergie de la structure sont sensiblement continues lorsque celle-ci est polarisée, caractérisée en ce que le dopage est réparti de façon inhomogène dans ladite zone à composition graduelle de sorte qu'il compense au moins partiellement le champ électrique inverse dû à la gradualité de la composition du matériau de la zone de transition.

## Description

La présente invention est relative aux photodiodes à avalanche et, notamment, mais non limitativement, aux photodiodes à avalanche réalisés à partir de matériaux semi-conducteurs III-V.

Les photodiodes à avalanche permettent d'obtenir des détecteurs de lumière à forte sensibilité et haute vitesse, par exemple pour des applications en transmission par fibre optique.

Elles comportent deux zones principales :
- la zone d'absorption qui est destinée à absorber les photons et dont le matériau et l'épaisseur dépendent respectivement de la longueur d'onde à détecter et de la rapidité de fonctionnement à obtenir ; cette zone caractérisée par une énergie de bande interdite relativement faible, en particulier pour les applications à 1,5 µm, est généralement soumise à un champ électrique modéré ;
- la zone de multiplication qui permet d'obtenir le gain interne grâce au phénomène d'avalanche ; celle-ci, de composition (matériau homogène ou structure multicouches) et d'épaisseur variables, est soumise à un très fort champ électrique.

Pour séparer la zone à fort champ électrique de la zone à champ modéré, on prévoit généralement entre ces deux zones une zone intermédiaire de transition.

Dans le cas notamment de photodiodes à avalanche en GaInAs/InP - destinées à la photodétection à 1,3-1,6 µm - il est impossible de faire fonctionner le matériau GaInAs de la zone d'absorption aux forts champs requis pour le matériau InP de la zone de multiplication et la séparation entre ces deux zones est indispensable.

La zone de transition est par exemple constituée par une couche d'InP ou d'AlInAs dopée uniformément afin d'obtenir la charge électrique de rupture de champ qui permet la coexistence d'un champ électrique modéré dans la zone d'absorption et d'un fort champ dans la zone d'avalanche.

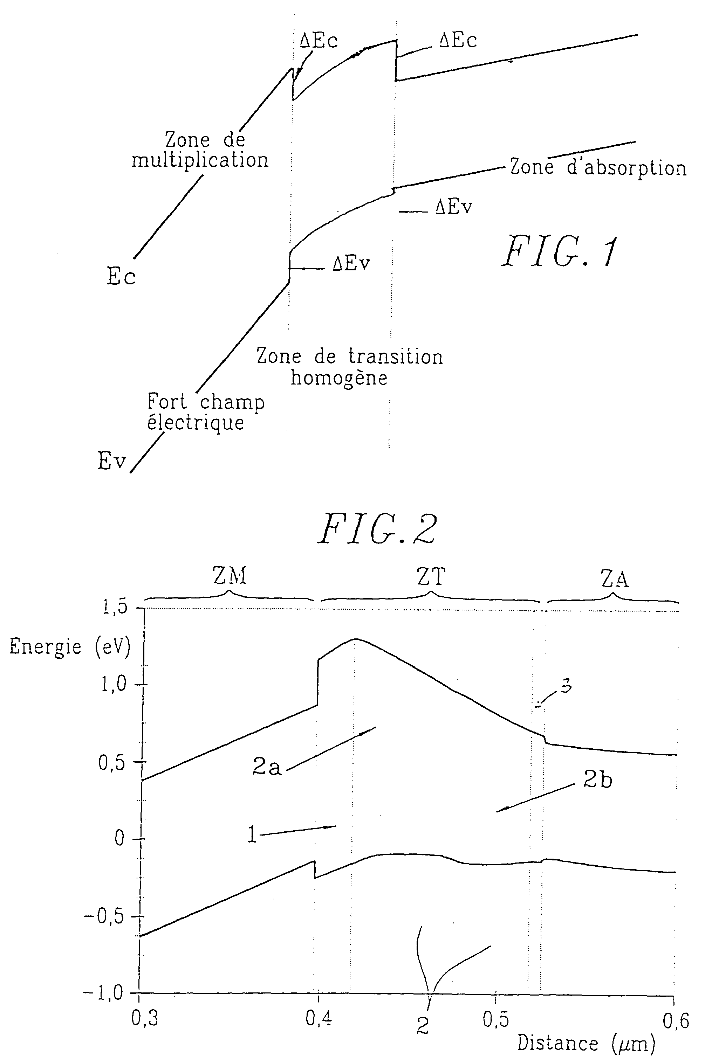

Des photodiodes à avalanche de ce type (généralement désignées par SAM ou "Separate Absorption and Multiplication" selon la terminologie anglo-saxonne), ont notamment été présentées dans les publications suivantes :
[1] T. Kagawa, Y. Kawamura and H. Iwamura : "InGaAsP-InAlAs superlattice avalanche photodiode", IEEE Journal of Quantum Electronics, Vol 28, n° 6, pp 1419-1423, June 1992 ;
[2] I. Watanabe, S. Sugou, H. Ishikawa, T. Anan, K. Makita, M. Tsuji and K. Tagushi : "High-speed and low dark current flip-chip InAlAs/InAlGaAs quaternary well superlattice APD's with 120 GHz gain-bandwidth product", IEEE Photonics Technology Letters, Vol 5, n° 6, pp 675-677, June 1993 ;
[3] S. Hanatani, H. Nakamura, S. Tanaka and T. Ido : "Flip-chip InAlAs/InGaAs superlattice avalanche photodiodes with back illuminated structures", Microwave and Optical Technology Letters, Vol 7, n° 3, pp 103-107, February 20, 1994.
   Toutefois, de telles photodiodes présentent, ainsi qu'on peut le voir sur la figure 1, des discontinuités des bandes de conduction et de valence (plusieurs dizaines de meV) de chaque côté de la zone de transition. Ceci peut entraîner notamment la capture des porteurs générés par l'absorption des photons ou l'ionisation par impact et est pénalisant pour les performances des photodiodes car le transport idéal des porteurs à vitesse élevée est perturbé. Cet effet est encore plus sensible à basse température.
   Plus récemment, il a été proposé des structures de photodiodes à avalanche, dont la zone de transition présente une ou plusieurs couches en GaInAsP formant ce que l'on appelle de façon abusive une zone de transition graduelle (photodiodes de type SAGM ou "Separate Absorption, Grading and Multiplication" selon la terminologie anglo-saxonne généralement utilisée).
   Ce concept a été repris et proposé dans : [4] Y. Le Bellego : "Photodiodes AlInAs/GaInAs pour transmissions optiques : Composants passivés à grande sensibilité et large bande passante", Thèse de l'université de Caen, 1991,
avec des photodiodes dont la zone d'avalanche est en un matériau à multipuits quantiques AlInAs/GaInAs, la zone d'absorption étant en GaInAs.

Du fait du rapport élevé entre les coefficients a et β d'ionisation par les électrons et par les trous (α/β∼10), de telles photodiodes à zone d'avalanche à multipuits quantiques sont susceptibles de présenter des performances particulièrement satisfaisantes (produit gain-bande élevé), dès lorsque l'on dispose de champs très homogènes et bien contrôlés dans les deux régions d'absorption et de multiplication.

Dans ces structures, le passage des électrons de la zone d'absorption à la zone d'avalanche se faisait à travers une zone de transition comprenant une première région en un matériau quaternaire non dopé de composition graduelle, et une seconde région de composition fixe (AlInAs) présentant un dopage p+ uniforme (dopage Be). En variante, la gradualité pouvait également être interne à la région dopée.

Une telle zone de transition permettait des bandes d'énergie continue, le niveau du dopage de ladite zone de transition conditionnant la répartition du champ dans la photodiode.

Toutefois, elle présentait l'inconvénient d'une part d'être peu compacte et d'autre part de conduire à des champs électriques inverses, s'opposant au passage des porteurs d'une zone à l'autre.

Un but de l'invention est donc de proposer une structure de photodiode qui est d'une plus grande compacité. Un autre but de l'invention est de proposer une une nouvelle structure de diode à avalanche, dont la zone de transition permet à la fois :
- une excellente séparation des niveaux de champ électrique de part et d'autre de la zone de transition;
- une configuration de bandes de conduction et de valence, qui facilite le passage des porteurs de l'une à l'autre des zones adjacentes à ladite zone de transition.

A cet effet, l'invention propose une photodiode à avalanche comportant une zone d'absorption, une zone de multiplication et une zone de transition disposée entre cette zone d'absorption et cette zone de multiplication, cette zone de transition présentant un dopage et étant constituée au moins en partie en un matériau à composition graduelle tel que les bandes d'énergie de la structure sont sensiblement continues lorsque celle-ci est polarisée, caractérisée en ce que le dopage est réparti de façon inhomogène dans ladite zone à composition graduelle de sorte qu'il compense au moins partiellement le champ électrique inverse dû à la gradualité de la composition du matériau de la zone de transition.

Par exemple, la principale partie de la charge se situe sur une portion de la zone à composition graduelle du côté de la zone d'avalanche.

Avantageusement, également, la zone de transition comporte en outre, du côté de la zone d'absorption, un plan de dopage qui a pour fonction de retarder l'extension de la zone de charge d'espace.

D'autres caractéristiques et avantages de l'invention ressortiront encore de la description qui suit. Cette description est purement illustrative et non limitative. Elle doit être lue en regard des dessins annexés sur lesquels :
- la figure 1, déjà analysée, est une représentation des niveaux d'énergie des bandes de conduction et de valence dans le cas d'une structure de photodiode de type SAM ;
- la figure 2 est un graphe sur lequel on a représenté les niveaux d'énergie des bandes de conduction et de valence, au voisinage de la zone de transition, d'une photodiode conforme à un mode de réalisation possible pour l'invention, cette photodiode n'étant pas soumise à polarisation ;
- la figure 3 est un graphe analogue à celui de la figure 2 sur lequel on a représenté les niveaux d'énergie des bandes de conduction et de valence de la même photodiode sous polarisation respectivement de 14 Volts et 25 volts ;
- la figure 4 est une représentation schématique d'une structure d'une photodiode à avalanche à puits quantique conforme à l'invention.

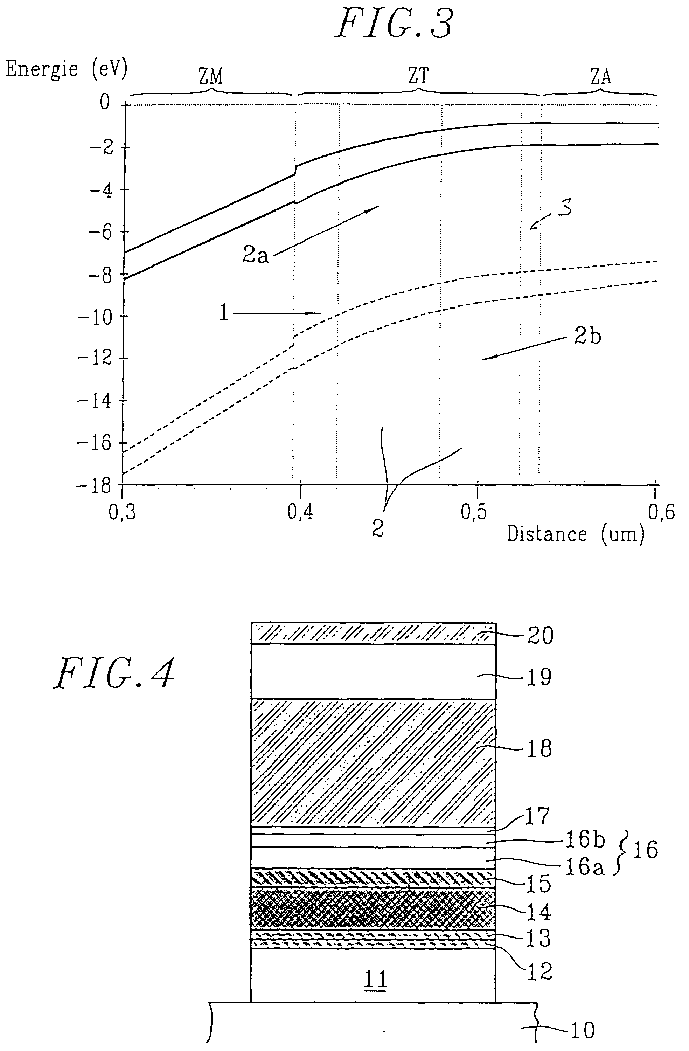

On se réfère aux figures 2 et 3 sur lesquelles on a porté les énergies des bandes de conduction et de valence d'une photodiode conforme à un mode de réalisation possible de l'invention.

Cette photodiode comporte une zone de multiplication ZM, une zone d'absorption ZA, ainsi qu'une zone de transition ZT disposée entre ces deux zones ZA et ZM.

La zone d'avalanche ZM présente avantageusement une structure à multipuits quantiques, ce qui permet de bénéficier d'un rapport α/β important. Sur les figures 2 et 3, les bandes d'énergie représentées sont dans ce cas des bandes d'énergie équivalentes.

La zone de transition ZT présente quant à elle, de la zone de multiplication ZM vers la zone d'absorption ZA :
- une zone 1 non dopée en un matériau de composition homogène ;
- une zone 2 en un matériau de composition graduelle, qui est constituée d'une première partie 2a qui présente un dopage de type p et d'une deuxième partie 2b qui est non dopée ;
- un plan de dopage de type p, référencé par 3 sur les figures.

La zone 1 non dopée est facultative. Elle permet d'éviter des diffusions de dopants dans les zones devant conserver un dopage résiduel et de séparer spatialement la charge des régions d'absorption et de multiplication.

La composition graduelle que présente la zone 2 permet de passer sensiblement continûment de l'énergie de bande interdite de la zone d'absorption à celle de la zone d'avalanche, de sorte que la photodiode ne présente que des discontinuités de bandes acceptables (idéalement aucune). C'est ce qui est illustré sur la figure 3, sur laquelle les bandes de conduction et de valence sont représentées sous polarisation de 14 volts (traits pleins) et de 25 volts (traits pointillés).

Le dopage de la zone 2a permet d'incorporer à la zone de transition ZT une charge électrique qui est nécessaire aux valeurs de champs électriques recherchées.

Le plan de dopage 3 a pour fonction de retarder l'extension de la zone de charge d'espace dans la zone d'absorption et permet ainsi de s'affranchir du champ électrique inverse intrinsèque à la gradualité. Son épaisseur et son niveau de dopage, c'est-à-dire la charge, dépendent des possibilités de la technique de croissance utilisée.

Avec une telle structure, la polarisation du dispositif conduit à aplatir la bande de conduction de la partie à gradualité de composition avant que le champ ne s'étende dans la zone d'absorption. La charge présente dans le plan de dopage 3 doit être ajustée en fonction de la structure et en particulier de la longueur de la gradualité.

On notera que la structure qui vient d'être décrite est particulièrement adaptée au cas d'un milieu d'avalanche dans lequel on injecte les électrons provenant de la zone d'absorption. Toutefois, une configuration symétrique permet d'obtenir un dispositif où ce sont les trous qui initient le phénomène de multiplication.

Le matériau de la zone 2 peut présenter une gradualité seulement partielle (de 10 à 90 % par exemple). De légères discontinuités de bandes subsistent dans ce cas.

En variante, il peut présenter une gradualité totale (de 0 à 100 %).

Une structure détaillée d'une photodiode à avalanche conforme à l'invention est illustrée sur la figure 4.

Cette structure comporte un substrat 10 d'InP dopé n+ sur lequel est déposé un empilement constitué des différentes couches successives suivantes :
- une couche 11 de GaAlInAs (Q50) de 5000 Å d'épaisseur, dopée n+ au silicium,
- une couche 12 d'AlInAs dopée n+ au silicium de 200 Å d'épaisseur,
- une couche 13 (n-) d'AlInAs de 300 Å d'épaisseur,
- une couche 14 (n-) à multipuits quantiques constituée de couches d'AlInAs alternant avec des couches de GaAlInAs T(Q30), l'épaisseur totale de cette couche à multipuits quantiques étant de 2 500 Å d'épaisseur, les couches d'AlInAs étant de 150 Å, celles de GaAlInAs de 100 Å,
- une couche 15 (n-) d'AlInAs de 200 Å d'épaisseur,
- une couche 16 graduelle dont une première partie 16a présente une épaisseur de 600 Å et est dopée p au béryllium (de 3,4 à 5.10¹⁷ cm⁻³ selon les réalisations) et dont une deuxième partie 16b de type n- présente une épaisseur de 400 Å et est non dopée, cette couche 16 étant en un matériau à composition graduelle de (InAlAs)_{0,1} (InGaAs)_{0,9} à (InAlAs)_{0,9}(InGaAs)_{0,1} (de 10 à 90 %),
- une couche 17 (InAlAs)_{0,1} (InGaAs)_{0,9} de 100 Å dopé au béryllium (5.10¹⁷ cm⁻³),
- une couche 18 de type n- de 1 µm de GaInAs,
- une couche 19 de GaAlInAs (Q50) dopée p+ au zinc de 500 Å d'épaisseur,
- une couche 20 de GaInAs de 300 Å d'épaisseur dopée p+ au zinc.

Les deux couches 11 et 12 déposées sur le substrat 10 définissent sur celui-ci une couche neutre

Les couches 11 et 12 constituent une couche neutre dopée n+ interposée entre le substrat 10 et la zone d'avalanche ZM.

Les couches 13 à 15 définissent cette zone d'avalanche ZM, la couche 15 étant une couche non dopée interposée pour séparer spatialement la couche à multipuits quantiques 14 qui constitue la région de multiplication, de la couche dopée de la zone de transition.

Cette zone de transition est constituée par les couches 16a, 16b et 17, la couche 17 définissant le plan de dopage de la zone de transition.

La couche 18 constitue la zone d'absorption.

La couche 19 constitue une couche intermédiaire S, la couche 20 constituant une couche de protection CP.

La structure qui vient d'être décrite constitue une photodiode à avalanche à multipuits quantiques pour un système de matériau AlInGaAs en accord de maille cristalline sur InP.

Cette photodiode est avantageusement utilisée pour des applications en transmission optique numérique au débit de 10 Gigabits/seconde à la longueur d'onde de 1,55 µm.

Bien entendu, l'invention n'est pas limitée à ce type de matériau et peut être appliquée quelle que soit la nature des régions d'absorption et d'avalanche et le système de matériaux utilisés (famille AlGaInASP à l'accord de maille ou non sur InP ou GaAs conducteurs ou semi-isolants, matériaux II-VI, etc...). Il suffit de pouvoir obtenir une gradualité avec le moyen de croissance employé (organo-métalliques en phase vapeur, jets moléculaires à sources solides ou gazeuses, jets chimiques,...).

## Revendications

1. Photodiode à avalanche comportant une zone d'absorption (ZA), une zone de multiplication (ZM) et une zone de transition (ZT) disposée entre cette zone d'absorption (ZA) et cette zone de multiplication (ZM), cette zone de transition (ZT) présentant un dopage et étant constituée au moins en partie (2) en un matériau à composition graduelle tel que les bandes d'énergie de la structure sont sensiblement continues lorsque celle-ci est polarisée, caractérisée en ce que le dopage est réparti de façon inhomogène dans ladite zone à composition graduelle de sorte qu'il compense au moins partiellement le champ électrique inverse dû à la gradualité de la composition du matériau de la zone de transition.

2. Photodiode selon la revendication 1, caractérisée en ce que la partie (2) en un matériau à composition graduelle de la zone de transition présente une partie non dopée (2b) et une partie dopée (2a) qui porte le dopage de charge.

3. Photodiode selon la revendication 2, caractérisé en ce qu'un plan de dopage (3) est juxtaposé à la partie non dopée (2b) du côté opposé au dopage de charge.

4. Photodiode selon la revendication 3, caractérisée en ce que le plan de dopage (3) sépare la zone d'absorption (ZA) de la zone non dopée (2b) de la partie à composition graduelle.

5. Photodiode selon l'une des revendications 3 et 4, caractérisée en ce que la partie dopée (2a) de la partie à composition graduelle (2) est séparée de la zone de multiplication par une zone intermédiaire non dopée (1).

6. Photodiode selon l'une des revendications précédentes, caractérisée en ce qu'au moins une partie de la zone de multiplication (21) est constituée par un empilement à multipuits quantiques.

7. Photodiode selon l'une des revendications précédentes, caractérisée en ce que la composition graduelle (2) de la zone de transition présente une gradualité totale.

8. Photodiode selon l'une des revendications 1 à 6, caractérisée en ce que la composition graduelle (2) de la zone de transition présente une gradualité seulement partielle.

9. Photodiode selon l'une des revendications précédentes, caractérisée en ce qu'elle est réalisée principalement en matériaux semi-conducteurs III-V.
